(19) Europäisches Patentamt
European Patent Office
Office européen des brevets

(11) EP 2 360 607 A1

(12) EUROPEAN PATENT APPLICATION

(43) Date of publication:
24.08.2011 Bulletin 2011/34

(51) Int Cl.:
*G06F 17/50* (2006.01)

(21) Application number: 10189434.3

(22) Date of filing: 29.10.2010

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.01.2010 US 295626 P**

(71) Applicants:
• **IMEC**
  **3001 Leuven (BE)**
• **Katholieke Universiteit Leuven, K.U. Leuven R&D**
  **3000 Leuven (BE)**

(72) Inventors:
• **Miranda, Miguel**
  **3010, Kessel-Lo (BE)**
• **Roussel, Philippe**
  **3210, Linden-Lubbeek (BE)**
• **Brusamarello, Lucas**
  **95082 080, Caxias do Sul - Rio Grande do Sul (BR)**

(74) Representative: **Hertoghe, Kris Angèle Louisa**
**DenK iP bvba**
**Hundelgemsesteenweg 1114**
**9820 Merelbeke (BE)**

(54) **Response characterization of an electronic system under variability effects**

(57) The present invention provides a method and a device for performing a characterization of a description of the composition of an electronic system in terms of a plurality of components used, performances of the plurality of components being described by at least two statistical parameters (21) and at least one deterministic parameter (22). The method according to embodiments of the present invention comprises selecting a plurality of design of experiments points, performing (24) simulations on the selected plurality of design of experiments points, thus obtaining system responses, and determining (25) a response model using the plurality of selected design of experiments points and the system responses. Selecting the plurality of design of experiments points comprises making a first selection of a reduced set of well chosen design of experiments points for the statistical parameters that are representative of the statistical properties of the many possible statistical parameter realizations, and making a second selection of design of experiments points for the at least one deterministic parameter that is representative of the possible limited set of values that such parameter can take.

FIG. 4

## Description

### Field of the invention

The present invention relates to methods for characterization of electronic systems under variability effects, e.g. process variability effects such as random process variability effects or effects of variability due to ageing, and to systems, apparatus and modeling tools implementing such methods.

### Background of the invention

Previously, new advances in CMOS circuit design primarily relied on technology improvements derived from scaling. Process variability and reliability issues of sub-45 nm CMOS devices significantly contribute to make electronic system responses (for instance delay and power of logic gates) random variables. Such process related issues have been imposing new challenges to the design of reliable integrated circuits.

Monte Carlo (MC) simulation is often employed for characterization of electronic components to obtain the probability density function (PDF) of the system output. Such approach allows variability-aware design to be implemented with minor changes to existing design tools. A large number N of runs is required for the statistical estimators to converge, since the error is $\approx 1/\sqrt{N}$. The problem with running MC simulations using thousands of simulations is that each simulation requires a long runtime and thus the MC simulation time becomes prohibitive.

The use of Design of Experiments in combination with Response Modeling is not new in electronic system modeling and its use was originally proposed by A. Alvarez, et al., in "Application of statistical design and response surface methods to computer-aided vlsi device design," IEEE Trans. on CAD, vol. 7, no. 2, pp. 272-288, Feb 1988.

US6381564 provides a method and system for providing optimal tuning for complex simulators. The method and system include initially building at least one RSM (response surface methodology) model having input and output terminals. Then there is provided a simulation-free optimization function by constructing an objective function from the outputs at the output terminals of the at least one RSM model and experimental data. The objective function is optimized in an optimizer and the optimized objective function is fed to the input terminal of the RSM. Building of at least one RSM model includes establishing a range for the simulation, running a simulation experiment for the designed experiment, extracting relevant data from said experiment and building the RSM model from the extracted relevant data. The step of running a simulation experiment comprises the step of running a DOE operation. The objective function is, for example, the square root of the sum of the squares at all of the differences between the target values and the observed values at all points being investigated.

Common to all known prior art solutions is the use of statistical un-aware DoE methods like Central-Composite-Design, full factorial and/or Box-Behnken Design.

### Summary of the invention

It is an object of embodiments of the present invention to reduce the simulation time required to statistically characterize an electronic system (for example a complete standard cell library consisting of several thousands of cells) from the hundreds of CPU-days required when using Monte Carlo simulations to a lot less, e.g. a few CPU-hours, with a reduction of several orders of magnitude in computation effort.

The above objective is accomplished by a method and device according to the present invention. By applying a method according to embodiments of the present invention or by using a device according to embodiments of the present invention, no accuracy is lost.

In a first aspect, the present invention provides a method, more particularly an automated method, for performing a characterization of a description of the composition of an electronic system, for example an essentially digital circuit, in terms of a plurality of components used, for example a transistor level circuit description, performances of the plurality of components, for example transistor variations, being described by at least two statistical parameters and at least one deterministic parameter. The statistical parameters and the at least one deterministic parameter may be due to variations in the manufacturing process of the plurality of components, to circuit or environmental conditions (e.g., changes in load, input slew rate due to noise, temperature, etc) and/or to degradation of the electronic component parameters as consequence of ageing. A technique according to embodiments of the present invention is generally applicable to any electronic system that comprises a set of electronic components wherein the system's response is affected by changes in the parameters that are responsible for its electrical behavior. Examples of such components can be electrical elements such as resistors, capacitors, diodes, transistors, or electrical sub-systems such as logic gates, memories, IP blocks. Moreover, the method according to embodiments of the present invention is particularly useful for electronic circuits and systems that are expressed using connectivity netlists of active electronic elements such as transistors and diodes and passive electronic elements such as resistors, inductors and capacitors. The method according to embodiments of the present invention comprises selecting a plurality of design of experiments points, performing simulations, e.g. electrical simulations or behavioral simulations, on the selected plurality of design of experiments points, thus obtaining system responses, e.g. electrical or behavioral system responses, and determining a response model via e.g. regression analysis, response surface approximation or any other suitable model estimation technique, using the plurality of selected design of experiments points and the system responses.

In accordance with embodiment of the present invention, selecting the plurality of design of experiments points comprises making a first selection of a reduced set of well chosen design of experiments points for the statistical parameters that are representative of the statistical properties of the many, thus theoretically unlimited, number of possible statistical parameter realizations, such as for example transistor threshold value and transistor gain, and making a second selection of design of experiments points for the at least one deterministic parameter that is representative of the possible limited set of values that such parameter can take, such as for example possible ranges in transistor slew rate and/or transistor load. Such combination of well chosen statistical design of experiment points and deterministic design of experiment points provides a compact, thus limited, set of design of experiment points capable of representing the properties of any, thus theoretically unlimited, combination of component parameters regardless of their nature, statistical and/or deterministic. Thus, such combinations of statistical and deterministic set of design of experiment points in accordance with embodiments of the present invention reduces the number of parameter combinations that need to be considered to obtain the response of the system via expensive simulations, e.g. electrical or behavioral simulations, from the many, thus theoretically unlimited, to a minimum set, hence reducing CPU-time effort by several orders of magnitude and increasing the speed of the simulations. The selection of the plurality of design of experiments points may be performed by technical means, such as for example a suitably programmed processor.

In embodiments of the present invention, selecting the plurality of design of experiments points may comprise entering a statistical confidence level, and making a first selection of DoE points for the statistical parameters may comprise selecting those points of a statistical parameter distribution which are representative of the statistical parameters based on representativeness of the statistical confidence level at a particular "distance" from the bulk of such statistical parameter distribution. It is therefore possible to define the area of interest of the statistical domain parameter where the method needs to provide maximum modeling accuracy which is system topology dependent. For instance, estimating the response of a memory cell memory requires having a good confidence level at distances six to nine sigma far off the bulk of the statistical population of the variation parameters, while for a logic cell such distance can be three to four sigmas. The distance required directly relates with the number of times an electronic component is included in the composition of the electronic system.

In embodiments of the present invention, making a first selection of design of experiment points for the statistical parameters may include constructing a "closed form" multi-dimensional probability density function (PDF) representing a multivariate statistics dataset of the description of the composition of the electronic system, the probability density function showing a distribution of statistical parameters, and selecting the design of experiments from such "closed form" multidimensional PDF which allows capturing the statistical correlations between parameters, which is otherwise not possible. Capturing such statistical correlations in a "closed form" is advantageous to guarantee a proper balance of accuracy of the obtained response model in the areas of the statistical input domain that have a reasonable probability against having less accuracy on these areas where the likelihood of the statistical realization of the parameter is very low.

Constructing a multi-dimensional probability density function representing multivariate statistics of the description of the composition of the electronic system in accordance with embodiments of the present invention may comprise partitioning the multivariate statistics dataset into a plurality of cluster components, fitting a multivariate, e.g. normal, distribution to each cluster component and determining its probability density function, and accumulating the multiple probability density functions of the different cluster components into a proportional sum weighted by cluster component size, this being the multi-dimensional probability density function representing the multivariate statistics dataset of the description of the composition of the electronic system.

In particular embodiments, the multi-dimensional probability density function may be n-dimensional, for example 2-dimensional, and the number of selected design of experiments points may be 2n+1. With this embodiment of the present invention, using a minimum of $2n+1$ points a model is guaranteed with cross-terms for the statistical parameters providing much better accuracy than the arbitrary selection of points used in prior art when applied to the selection of such statistical points.

In accordance with embodiments of the present invention, the number of deterministic DoE points depends on the chosen technique for their selection. As an example, the selection of the deterministic DoE may be done according to existing techniques, such as e.g., Central-Composite-Design, full factorial and/or Box-Behnken Design. The number of selected deterministic DoE points should preferably be limited, as an enlarged number of deterministic DoE points leads to an enlarged number of simulations required for a later model fitting step.

The multi-dimensional probability density function may be represented in a PDF contour plot by an ellipsoid contour, the ellipsoid contour having principal ellipsoid axes, in which case the design of experiments points may be selected as lying on the one hand within a predetermined first margin of the ellipsoid describing the contour encompassing a predetermined percentage of the total distribution and on the other hand within a predetermined second margin of the intersects thereof with the principal ellipsoid axes. In particular embodiments, the design of experiments points may be selected as lying both on the ellipsoid describing the contour encompassing a predetermined percentage of the total distribution an on the intersects thereof with the principal ellipsoid axes.

A method according to embodiments of the present invention may furthermore comprise determining a plurality of samples by performing a statistical analysis, such as for example Monte Carlo (MC) simulation, on the determined response model.

A method according to embodiments of the present invention may furthermore comprise generating a closed-form representation of the determined plurality of samples representing a multivariate statistics dataset of the description of the composition of the electronic system using a probability density function of the statistical distribution of statistical parameters.

In a method according to embodiments of the present invention, determining a response model may comprise detecting and removing linear terms that have a negligible contribution to the system response.

A method according to embodiments of the present invention may furthermore comprise, before selecting a plurality of design of experiments points, identifying individual components, e.g. electrical elements or sub-systems, which have no or only limited influence on the system response.

A method according to particular embodiments of the present invention provides a time-efficient and accurate system characterization flow based on Design of Experiments and system response modeling, e.g. Response Surface Methodology. The approach is suitable for substituting Monte Carlo simulations at the electric level. The methodology is accurate because a new DoE is implemented, capable of capturing statistical information about the input variables. On the top of that, non-linear regression models may be employed to model the system responses. Moreover, the approach is time-efficient because the number of simulations is reduced by 2 orders of magnitude comparing to conventional MC, without loss of accuracy because of the items described above.

In a second aspect, the present invention provides a system-level simulator adapted for carrying out a method according to an embodiment of the present invention.

A system-level simulator according to embodiments of the present invention, comprises

an input port for receiving a description of the composition of an electronic system in terms of a plurality of components used,

an input port for receiving a distribution of statistical properties of the performances of the plurality of components of the electronic system,

an input port for receiving a distribution of at least one deterministic parameter of the plurality of components of the electronic system,

a selector for selecting a plurality of design of experiments points,

a simulator for performing simulations on the selected plurality of design of experiments points, thus obtaining electrical system responses,

a modeling unit for determining a response model using the plurality of selected design of experiments points and the electrical system responses,

wherein the selector comprises a first sub-selector for making a first selection of design of experiments points for the statistical parameters and a second sub-selector for making a second selection of design of experiments points for the at least one deterministic parameter.

A system-level simulator according to embodiments of the present invention may furthermore comprise an input port for receiving a statistical confidence level, and the selector may be adapted for selecting those points of a statistical parameter distribution which are representative of the statistical parameters based on representativeness of the statistical confidence level at a particular "distance" of the bulk of such statistical parameter distribution.

A system-level simulator according to embodiments of the present invention may furthermore comprise a processor for constructing a multi-dimensional probability density function representing multivariate statistics of the description of the composition of the electronic system, the probability density function showing a distribution of statistical parameters, and for selecting the plurality of design of experiments points based on the distribution of statistical parameters.

The present invention also provides a computer program product for executing a method according to embodiments of the present invention when executed on a computing device associated with a system-level simulator.

A machine readable data storage storing the computer program product according to embodiments of the present invention is also provided. The terms "machine readable data storage" or "carrier medium" or "computer readable medium" as used herein refer to any medium that participates in providing instructions to a processor for execution. Such a medium may take many forms, including but not limited to non-volatile media, volatile media and transmission media. Non-volatile media include, for example, optical or magnetic disks, such as a storage device which is part of mass storage. Volatile media include dynamic memory such as RAM. Common forms of computer readable media include, for example, a floppy disk, a flexible disk, a hard disk, magnetic tape or any other magnetic medium, a CD-ROM, any other optical medium, punch cards, paper tapes, any other physical medium with patterns of holes, a RAM, a PROM, an EPROM, a FLASH-EPROM, any other memory chip or cartridge, a carrier wave as described hereafter, or any other medium from which a computer can read.

Various forms of computer readable media may be involved in carrying one or more sequences of one or more instructions to a processor for execution. For example, the instructions may initially be carried on a magnetic disk of a remote computer. The remote computer can load the instructions into its dynamic memory and send the instruction over a telephone line using a modem. A modem local to the computer system can receive the data on the telephone line and use an infrared transmitter to convert the data to an infrared signal. An infrared detector coupled to a bus can receive the data carried in the infrared signal and place the data on the bus. The bus may carry data to main memory, from which a processor may retrieve and execute the instructions. The instructions received by main memory may optionally be stored on a storage device either before or after execution by a processor. The instructions can also be transmitted via a carrier wave in a network, such as a LAN, a WAN or the internet. Transmission media can take the form of acoustic or light waves, such as those generated during radio wave and infrared data communications. Transmission media include coaxial cables, copper wire and fiber optics, including the wires that form a bus within a computer. In an aspect, the present invention thus provides transmission of the computer program product according to an embodiment of the present invention over a local or wide area telecommunications network.

In a further aspect, the present invention provides transmission over a local or wide area telecommunications network of results of a method implemented by a computer program product according to embodiments of the present invention and executed on a computing device associated with a system-level simulator. Here again, the signals can be transmitted via a carrier wave in a network, such as a LAN, a WAN or the internet. Transmission media can take the form of acoustic or light waves, such as those generated during radio wave and infrared data communications. Transmission media include coaxial cables, copper wire and fiber optics, including the wires that form a bus within a computer. In an aspect, the present invention thus provides transmission of the results of methods according to an embodiment of the present invention over a local or wide area telecommunications network.

It is an advantage of the methodology for characterization of electronic systems according to embodiments of the present invention that it leads to a two orders of magnitude speedup compared to Monte Carlo, without noticeable loss of accuracy.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

**Brief description of the drawings**

FIG. 1 illustrates a traditional Monte Carlo flow for system characterization.

FIG. 2 illustrates a basic method flow according to embodiments of the present invention.

FIG. 3 illustrates a characterization flow according to particular embodiments of the present invention.

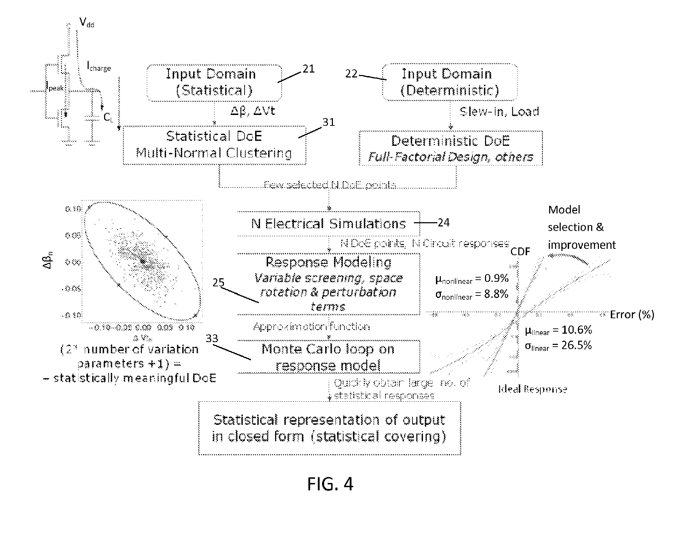

FIG. 4 shows an overview of a method according to embodiments of the present invention.

FIG. 5 illustrates a probability density function generated using a Multicluster Bivariate Normal algorithm (k=1) for $\Delta V_t$ and $\Delta\beta$ of a NMOS device.

FIG. 6 illustrates the selected Statistical Design of Experiments preserving the correlations among statistically parameters positioned at a region of interest via selectable confidence level. Large square dots represent the selected DoE points.

FIG. 7 shows fitted values and residuals of a full linear response model.

FIG. 8 shows fitted values and residuals of a nonlinear response model obtained by an optimization algorithm according to embodiments of the present invention.

FIG. 9 visualizes a high-level description of a method according to embodiments of the present invention to obtain a sub-linear dependency between the required number of DoE points and the number of electronic components in an electronic system.

FIG. 10 visualizes a description of sub-steps implemented in accordance with embodiments of the present invention to identify a subset of electronic components of an electronic system of which the state changes during system operation.

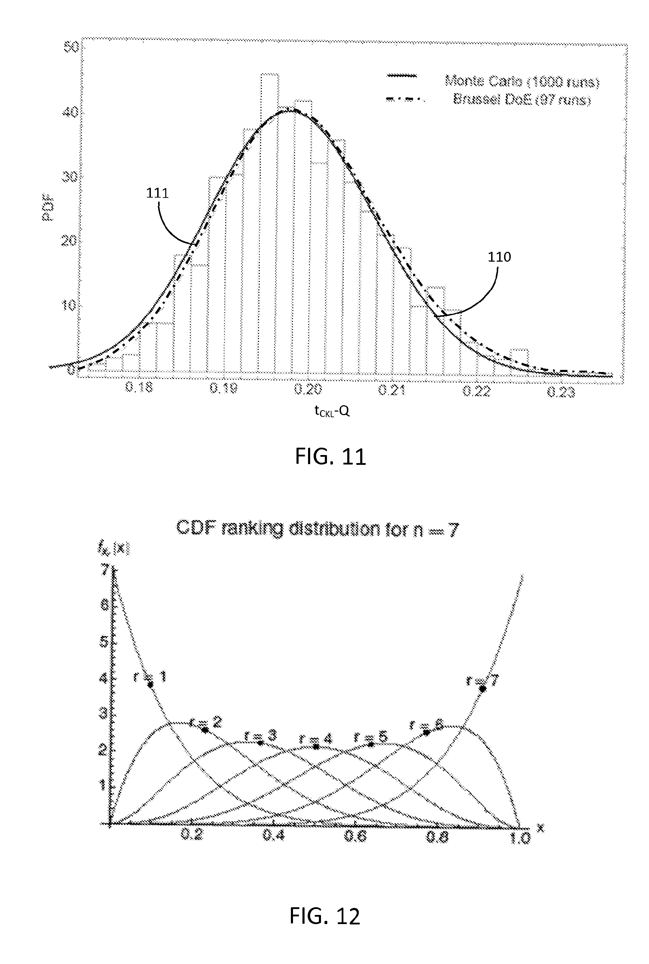

FIG. 11 compares the histogram of the distribution of the delay between the clock and the Q output signal of a Flip-Flop when computed using 1000 MC electrical simulations (graph 110) and 97 Statistical Design of Experiment points (graph 111). The minimum number of points is 97 because the Flip-Flop contains 24 electronic components, being all transistors and each transistor is subject to 2 variation parameters ($V_t$ and $\beta$), hence the minimum number of design of experiment points is (2x(2x24)+1). In this example the number of deterministic parameters is limited to one: only one particular combination of load and input slew rate at the clock input is considered.

FIG. 12 illustrates the PDF of a regularized Beta distribution for n=7 and ranks 1 to 7.

FIG. 13 illustrates rank probit distributions for n=7 .

FIG. 14 illustrates PDF and FIG. 15 illustrates CDF of a $\Delta V_{th}$ distribution.

FIG.16 illustrates the PDF of the NAND delay comparing RSM in accordance with embodiments of the present invention (17 electrical simulations) to Monte Carlo HSPICE (1000 electrical simulations).

FIG.17 illustrates a Probit plot of NAND delay comparing RSM in accordance with embodiments of the present invention (17 electrical simulations) to Monte Carlo HSPICE (1000 electrical simulations).

FIG.18 illustrates a comparison between MC using a sample size of 100 and 1000, respectively, with RSM using a sample size of 1000.

FIG. 19 illustrates the error of a linear RSM compared to a non-linear RSM.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

## Detailed description of illustrative embodiments

An electronic system is often constructed from a plurality of electronic components, which may per se be electronic subsystems such as logic gates, memories or IP blocks, or active or passive electronic elements such as transistors, diodes, resistors, capacitors. For example, a digital circuit is often constructed from small electronic circuits called logic gates. Each logic gate represents a function of Boolean logic. A logic gate is an arrangement of electrically controlled switches, most often implemented by means of electronic components, for example transistors.

On-chip-variations (OCV), for example in the fabrication process of electronic elements such as MOS devices or for example due to ageing, cause electronic components such as electronic elements, e.g. transistors, to present different electrical characteristics even when they have the same geometries. Basically these variations in the electronic component electrical characteristics cause their I-V curves to be different. At the electric level, the various I-V curves resulting from variability due to process variations or due to ageing can be modeled as variations in the main electrical characteristics of the electronic components: e.g. voltage and current, for example $V_t$ and $I_{ds}$ in case of transistors.

The distributions of the parameters subject to variations due to manufacturing imperfections, environmental noise, degradation and/of ageing effects, such as e.g. $\Delta V_t$ and $\Delta \beta$ in case of transistors, may be computed through statistical simulation, e.g. Monte Carlo (MC) simulation, of a commercial technology model card. Alternatively, those distributions could as well come from chip measurements. These distributions are inputs to the system characterization flow according to embodiments of the present invention, as well as the system netlist.

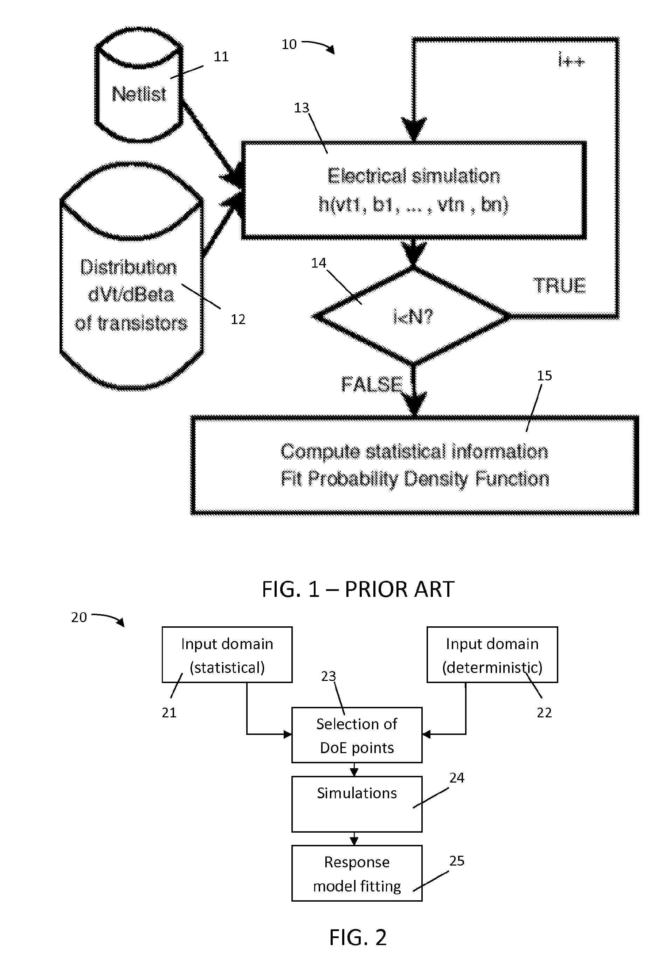

FIG. 1 shows a traditional system characterization flow 10 based on Monte Carlo simulations at electric level. A netlist 11 describing the connectivity of the components in the electronic system and information 12 relating to the statistical distribution of parameters relating to the electronic components, (e.g. electronic elements such as transistors, diodes, resistors, capacitors; but also larger groupings of electronic elements such as sub-systems e.g. logic gates, memories, IP blocks; in essence any electronic components comprising inputs/outputs and parameters responsible for their response), in the electronic system are input into a simulation unit, e.g. statistical distributions on the deviations on threshold voltage $V_t$ and source-drain current $I_{ds}$. Electrical simulations are performed 13 for N combinations of these parameters from the distribution. The accuracy of the estimators obtained using this prior art flow is limited by the number of electrical simulations N, since the error is approximately $\propto 1/\sqrt{N}$. Thus, usually the inputting of the netlist and the statistical distribution is repeated - step 14, and a large number N of simulations (often N > 1000) is required to satisfy the accuracy required for characterizing transistor level system descriptions. Fluctuations in $V_t$ and $\beta$ are inserted by vaccination considering these parameters as random variables. Based on the large number of simulations, statistical information is computed, and a probability density function is fit through the computed statistical information - step 15.

An alternative case, corresponding to embodiments of the present invention is described in FIG. 2.

In a first aspect, the present invention provides a method 20 for performing a characterization of a description of the composition of an electronic system in terms of a plurality of electronic components used, such as electronic elements as for example resistors, capacitors, diodes, transistors, or sub-systems comprising a plurality of electronic elements, such as logic gates, memories, IP blocks. The performances of the plurality of electronic components under consideration, e.g. transistor variations, are described by at least two statistical parameters 21, such as for example variations on threshold voltage $V_t$ and variations on gain $\beta$, and at least one deterministic parameter 22 such as for example slew rate or load. The method comprises selecting - step 23 - a plurality of design of experiments points, performing simulations, e.g. electrical simulations or behavioral simulations, on the selected plurality of design of experiments points - step 24 - thus obtaining system responses, and determining a response model using the plurality of selected design of experiments points an the system responses - step 25. In accordance with embodiments of the present invention, selecting the plurality of design of experiments points - step 23 - comprises making a first selection of design of experiments points from the statistical parameters and making a second selection from design of experiments point from the at least one deterministic parameter. It is advantageous to use a combination of statistical and deterministic design of experiments points in accordance with embodiments of the present invention because such combination of well-chosen statistical design of experiment points and deterministic design of experiment points provides a compact, thus limited, set of design of experiment points capable of representing the properties of any, thus theoretically unlimited, combination of component parameters regardless of their nature, statistical and/or deterministic. Thus, such combinations of statistical and deterministic set of design of experiment points reduces the number of parameter combinations that need to be considered to obtain the response of the system via expensive simulations from the many, thus theoretically unlimited, to a minimum set, hence reducing CPU-time effort by several order of magnitude and increasing the speed of the simulations.

In particular embodiments of the present invention, selecting the plurality of design of experiments points comprises entering a statistical confidence level. The statistical confidence level is expressed as a percentage, and represents the border line of a region within which the total probability that parameter combinations confined by it occur is equal to the confidence level. In this case, making a first selection of design of experiments points for the statistical parameters comprises selecting those points of a statistical parameter distribution which are representative for the statistical parameters based on representativeness of the statistical confidence level at a particular "distance" of the bulk of such a statistical parameter distribution.

In summary, embodiments of the present invention feature the following aspects:

- **Statistical Aware**: Unlike deterministic DoE approaches (e.g., Central-Composite-Design, full factorial and/or Box-Behnken Design) the Statistical DoE in accordance with embodiments of the present invention selects only design points that are statistically relevant to the parameter domain distribution.
- It considers **Input Correlations**: The statistical DoE in accordance with embodiments of the present invention properly captures the existing correlation between input parameters. • The Response Model may be based on an **Open Model**: the model estimating the system response may be selected on-the-fly and is not limited to a predefined template function.
- The approach works under **Non-Normality** assumption, not limited to assumptions of any nature for the underlying statistical distribution of the process parameters (e.g., Gaussian, lognormal, etc).
- It allows a selectable level of confidence in a region of interest.

In particular embodiments, the present invention provides a method for performing a characterization of a description of the composition of an electronic system in terms of a plurality of electronic components used. The performances of the plurality of electronic components under consideration, e.g. transistor variations, are described by at least two statistical parameters, such as for example variations on threshold voltage $V_t$ and variations on gain $\beta$, and at least one deterministic parameter such as for example slew rate or load. Hence the input domain is separated into a statistical and a deterministic domain. The method comprises making a first selection of design of experiments points from the statistical parameters and making a second selection from design of experiments point from the at least one deterministic parameter, performing simulations on the selected plurality of design of experiments points thus obtaining electrical system responses, and determining a response model using the plurality of selected design of experiments points an the electrical system responses. In accordance with this embodiment, making a first selection of design of experiment points for the at least two statistical parameters includes constructing a multi-dimensional probability density function representing multivariate statistics of the description of the electronic system, the probability density function showing a distribution of statistical parameters, and selection of the design of experiment points for the statistical parameters being based on the distribution of statistical parameters.

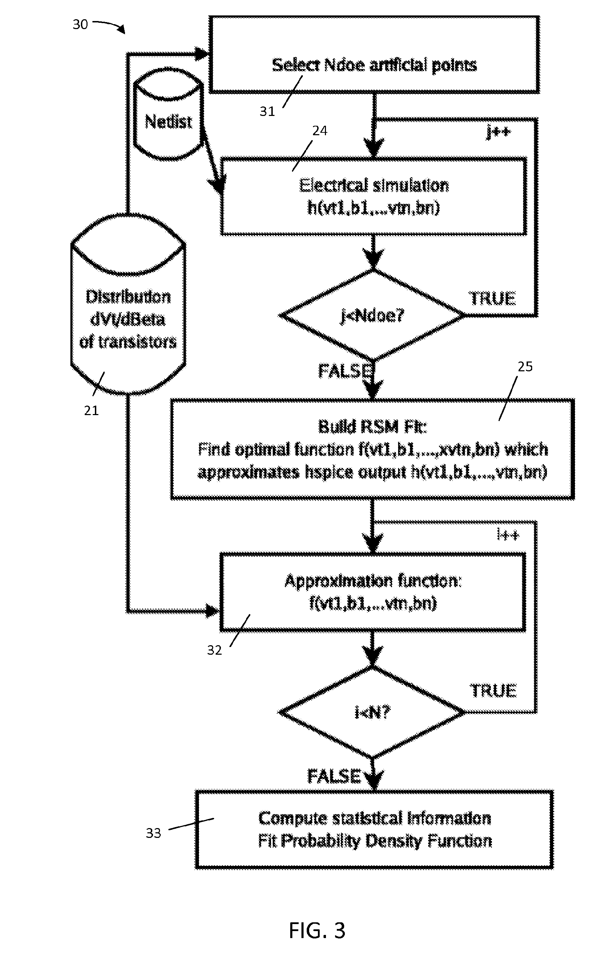

FIG. 3 shows a flow 30 describing steps in accordance with this embodiment to perform characterization of a description of the composition of an electronic system in terms of a plurality of components used, which flow aids in obtaining a two orders of magnitude speedup compared to the conventional flow as illustrated in FIG. 1.

The input domain is separated into a statistical and a deterministic domain. FIG. 3 only shows the part of the present invention taking into account statistical variations, and, although part of the present invention, does not illustrate statistical variations of parameters. A pre-processing step 31 is carried out on the statistical input domain to determine a small set of $N_{doe}$ artificially generated points that represent the original sample of N random statistical parameters, e.g. $\Delta V_t$ and $\Delta\beta$. The tremendous speedup of the flow in accordance with this embodiment of the present invention relies on the fact that $N_{doe} \ll N$, so the number of simulations to be carried out in step 24 is much smaller. After the $N_{doe}$ selected simulations, a response model is determined - step 25 - using the plurality of selected design of experiments points and the system responses obtained in step 24. This may for example be done by a model selection algorithm which searches for an optimal non-linear regression model relating inputs to outputs hence representing the outcome of the simulations.

After this, a large amount of statistical simulations, e.g. MC experiments, can be run using the response model, e.g. RSM model, - step 33 -, because computing one run of such statistical simulation, for example one run of the regression function, is very fast.

The pre-processing step 31 according to embodiments of the present invention is now looked at in more detail.

The first step in order to achieve a good response model, e.g. a good response surface fit, is to perform a design of experiments. The goal of this stage is to find $N_{doe}$ points that are representative for the n-dimensional input space. In embodiments of the present invention, the n input variables are random variables. In one particular embodiment, the n-dimensional input space is a two-dimensional input space, for example having as statistical parameters a variation $\Delta V_t$ on the threshold voltage and a variation $\Delta\beta$ on the gain.

Problem definition: Let a Monte Carlo ensemble $\Gamma^M$ of size N of the n-dimensional function be given by

$$\Gamma^M = \{\{Vt_1, \beta_1, \ldots, Vt_n, \beta_n\}_1, \ldots, \{Vt_1, \beta_1, \ldots, Vt_n, \beta_n\}_{NMC}\}.$$

Find an alternative ensemble $\Gamma^B$ with size $N_{doe}$ given by

$$\Gamma^B = \{\{Vt_1, \beta_1, \ldots, Vt_n, \beta_n\}_1, \ldots, \{Vt_1, \beta_1, \ldots, Vt_n, \beta_n\}_{Ndoe}\}$$

which is a good representation of the original input domain of the sample $T^M$.

The novel DoE technique according to embodiments of the present invention exploits existing knowledge about the statistical input variable domain to be sampled. This DoE allows fitting a response model, e.g. a linear response surface, that offers a proper balance between accuracy and input variable validity range. It also allows sufficient redundancy to enable extension to higher order approximations (2nd or even 3rd order) of a limited selection of terms. Higher order approximations are allowed if negligible terms are previously deleted, because by doing so degrees of freedom are freed.

To select appropriate points according to the DoE technique in accordance with embodiments of the present invention there are two steps: 1) build an n-dimensional probability density function (PDF) representing the multivariate statistic of the description of the composition of the electronic system as a function of a plurality of components used, the PDF showing a distribution of statistical parameters, and 2) proper selection of 2n+1 DoE points based on the distribution of statistical parameters. These steps are described in more detail below.

The first step to construct the n-dimensional PDF, e.g. a multinormal n-dimensional PDF, is to partition the dataset into a plurality, k, of cluster components. According to one embodiment, "an information criterion", also known as Bayesian Information Criteria (BIC) proposed by Schwarz , may be used as a method for selecting an optimal number k of cluster components. BIC is a measure of the goodness of fit of an estimated statistical model. In particular embodiments, a good number k of cluster components may be in the range 1 to 3. A clustering algorithm, for instance hierarchical clustering, may be applied to partition the dataset $\{V_{t1}, \beta_1, \ldots, V_{tn}, \beta_n\}$ into k cluster components. In particular embodiments the partitioning may for example be based upon a unit free, rescaled Euclidian distance criterion, which is a robust version of a Mahalanobis distance, thus guaranteeing a good partitioning when the dimensions have different units.

After clustering, a multivariate continuous probability distribution, e.g. a multivariate Normal distribution, is fitted to each cluster component $\{V_{t1}, \beta_1, \ldots, Vtn, \beta_n\}_i$. The PDF of a multivariate Normal distribution for a single component cluster i is described as:

$$f_i(\vec{t}, \vec{\mu}_i, S_i) = \frac{e^{-\frac{1}{2}(t-\mu_i).S_i^{-1}.(t-\mu_i)}}{(2\pi)^{\frac{n}{2}}\sqrt{|S_i|}} \qquad (1)$$

wherein $\overleftarrow{\mu}$ is the vector of central value of the variables, S is the covariance matrix of the variables which is given by:

$$S = \begin{pmatrix} \sigma_1^2 & \rho_{12}\sigma_1\sigma_2 & \cdots & \rho_{1n}\sigma_1\sigma_n \\ \rho_{12}\sigma_2\sigma_1 & \sigma_2^2 & \cdots & \rho_{2n}\sigma_2\sigma_n \\ \vdots & \vdots & \ddots & \vdots \\ \rho_{1n}\sigma_n\sigma_1 & \rho_{2n}\sigma_n\sigma_2 & \cdots & \sigma_n^2 \end{pmatrix} \qquad (2)$$

wherein $\rho_{lm}$ is the correlation between variables l and m.

Then the multiple PDF's are accumulated, for example into a proportional sum weighted by cluster component size:

$$f(\vec{t}) = \frac{\sum_{i=1}^{k} w_i f_i(\vec{t}, \vec{\mu}_i, S_i)}{\sum_{i=1}^{k} w_i} \qquad (3)$$

where $\overleftarrow{\mu}_i$ and $S_i$ are $\overleftarrow{\mu}$ and S of the variables of the cluster component i, $w_i$ is its size. The sum weighted by cluster size is the best way to account for the different regions of the distribution. One possible alternative, however less advantageous, is Kernel Density Estimation, which has all clusters with size equal to 1.

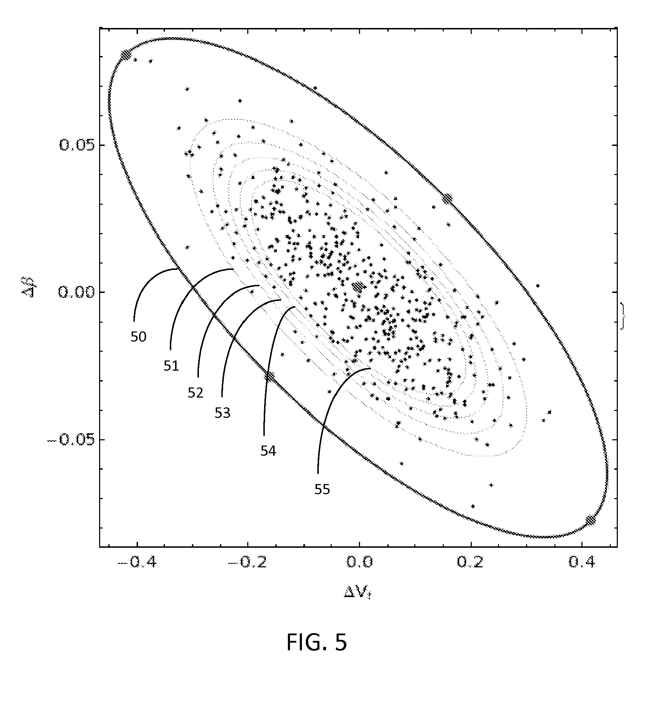

Each data cluster generates a different covariance matrix S. It is to be noted that this approach excludes single data point cluster components, distinguishing this method for example from Kernel Density Estimation. FIG. 5 presents the result of the procedure described for a 2-dimensional combination of {ΔVt, Δβ} of a NMOS device. It can be seen that the built PDF function representing the 2-dimensional statistic shows a distribution of statistical parameters. The different regions 50, 51, 52, 53, 54, 55 in Fig. 5 correspond to the different regions each having a different confidence level as introduced above.

Preliminary values for the distribution parameters are computed from each cluster component sample statistically. This surrounds each cluster component mean with a Gaussian bell shape representing the diminishing weight of the cluster component as the PDF is interpolated at a greater distance from the component mean.

As the clustering algorithm specifically attributes each of the statistical samples of the statistical input domain to a specific cluster component, it is advisable to refine the preliminary distribution parameter values, for example with a maximum likelihood (ML) fitting algorithm. Because the ML values for a single component multinormal distribution are equal to the preliminary estimators, this refinement step can be skipped for single cluster component approximations.

After building the n-dimensional PDF function representing the multivariate statistic of the description of the composition of the electronic system, the DoE points are selected.

Hereto, each covariance matrix S may be decomposed using the diagonal matrix of σ values for each variable:

$$S = \sigma \cdot \rho \cdot \sigma, \text{with} \qquad (4)$$

$$\boldsymbol{\sigma} = \begin{pmatrix} \sigma_1 & 0 & \cdots & 0 \\ 0 & \sigma_2 & \cdots & 0 \\ \vdots & \vdots & \ddots & \vdots \\ 0 & 0 & \cdots & \sigma_n \end{pmatrix}$$

(5)

where σ is extracted as the square root of the matrix diagonal, so that ρ becomes the corresponding correlation matrix:

$$\boldsymbol{\rho} = \begin{pmatrix} 1 & \rho_{12} & \cdots & \rho_{1n} \\ \rho_{12} & 1 & \cdots & \rho_{2n} \\ \vdots & \vdots & \ddots & \vdots \\ \rho_{1n} & \rho_{2n} & \cdots & 1 \end{pmatrix}$$

(6)

In effect, this standardizes the variables into unit free ones:

$$f(\vec{t}, \vec{\mu}, \mathbf{S}) = \frac{e^{-\frac{1}{2}\left(\frac{t-\mu}{\sigma}\right) \cdot \boldsymbol{\rho}^{-1} \left(\frac{t-\mu}{\sigma}\right)}}{(2\pi)^{\frac{n}{2}} \cdot \sqrt{|\mathbf{S}|}}$$

(7)

Next, a principal value decomposition of the correlation matrix may be performed:

$$\boldsymbol{\rho} = \mathbf{R}^T \cdot \mathbf{E} \cdot \mathbf{R}$$

(8)

where R is a rotation matrix, and E is the diagonal matrix of Eigenvalues:

$$\mathbf{E} = \begin{pmatrix} e_1 & 0 & \cdots & 0 \\ 0 & e_2 & \cdots & 0 \\ \vdots & \vdots & \ddots & \vdots \\ 0 & 0 & \cdots & e_n \end{pmatrix}$$

(9)

Overall, the covariance matrix of each cluster component may thus be decomposed as:

$$\mathbf{S} = \boldsymbol{\sigma} \cdot \mathbf{R}^T \cdot \mathbf{E} \cdot \mathbf{R} \cdot \boldsymbol{\sigma}$$

(10)

This decomposition describes a rotation of the variables into an equivalent set of independent Studentized variables $t_p$ (studentized variables are variables which are adjusted by division by an estimate of a standard deviation of a population):

$$\vec{t}_p = \frac{\mathbf{R} \cdot \dfrac{\vec{t} - \vec{\mu}}{\vec{\sigma}}}{\sqrt{\vec{E}}} \qquad (11)$$

In the PDF contour plot, when the contours are ellipsoids, e.g. when approximating the distribution of the stochastic input parameters with a multinormal, the orientation of the rotated standardized axis system corresponds with the principal axes of ellipsoid contours of the multivariate PDF description.

$$f(\vec{t}, \vec{\mu}, \mathbf{S}) = \frac{e^{-\frac{1}{2} t_p \cdot t_p}}{(2\pi)^{\frac{n}{2}} \cdot |\boldsymbol{\sigma}| \cdot \sqrt{|\mathbf{E}|}} \qquad (12)$$

wherein

$$\sqrt{|\mathbf{S}|} = |\boldsymbol{\sigma}| \cdot \sqrt{|\mathbf{E}|} = \prod_{j=1}^{n} \sigma_j \sqrt{\prod_{j=1}^{n} e_j} \qquad (13)$$

A next step is to find the ellipsoid describing the contour encompassing a specified confidence level, i.e. a predetermined percentage of the total distribution, e.g. 99.73%. In terms of total PDF content, this particular value corresponds with the 3σ limits in the univariate case. This useful concept for univariate statistics becomes ill defined in a multivariate context, however.

The $\chi 2$ distribution with v degrees of freedom gives the distribution of sums of squares of v values sampled from a normal distribution, so its CDF (Cumulative distribution function) can be used to sample the total probability covered by a hypersphere with a given radius. Thus, the ellipsoid describing the contour encompassing a specified percentage of the total distribution is defined by back-transforming the hypersphere with the radius defined by the inverse CDF of the $\chi 2$ distribution:

$$q\chi^2 = \sqrt{2 f_\Gamma^{-1}\left(\frac{n}{2}, 0, p\sigma\right)}$$

where $f_\Gamma$ is the Regularized Gamma Distribution $p\sigma = \int_0^{t^2} \chi^2(t, v)\, dt$ with v = 1 (one dimension) and $l$ refers to how many σ from the center the designer wants to be confident on the outcome, i.e. $l \times \sigma_s$. If $l$=3 then $p\sigma$ = 0.9973. Therefore, in terms of total PDF content, this value is the generalization of the 3σ limits valid for the univariate case. Next, the corresponding ellipsoid contour in the rotated parameter space is defined by:

$$Ellipsoid \begin{cases} \vec{c} = [0]_n \\ \vec{r} = q\chi^2 \sqrt{\vec{e}} \\ D = R \end{cases}$$

which represents a n-dimensional ellipsoid centered at the origin with semi-axis radii $q\chi^2 \sqrt{\vec{e}}$ aligned with the direction *R.*

In accordance with embodiments of the present invention, 2n+1 DoE points are selected. In accordance with embodiments of the present invention, DoE points may be selected which are lying on the one hand within a predetermined first margin of the ellipsoid describing the contour encompassing the specified confidence level, and on the other hand within a predetermined second margin of the intersects thereof with the principal ellipsoid axes. In particularly preferred embodiments, the DoE points may be selected which are positioned at the intersects of the ellipsoid principal axes and that PDF contour. Also, an extra DoE point is added at the component center. This way, upfront relevant simulations to run are selected.

A response model, e.g. a response surface, can then be fitted to those selected DoE points. This approach offers a proper balance between sufficient accuracy and validity over the input variable range required for further statistical simulation, e.g. MC sampling, while still requiring a limited amount of terms in the generic propagation function to be fitted.

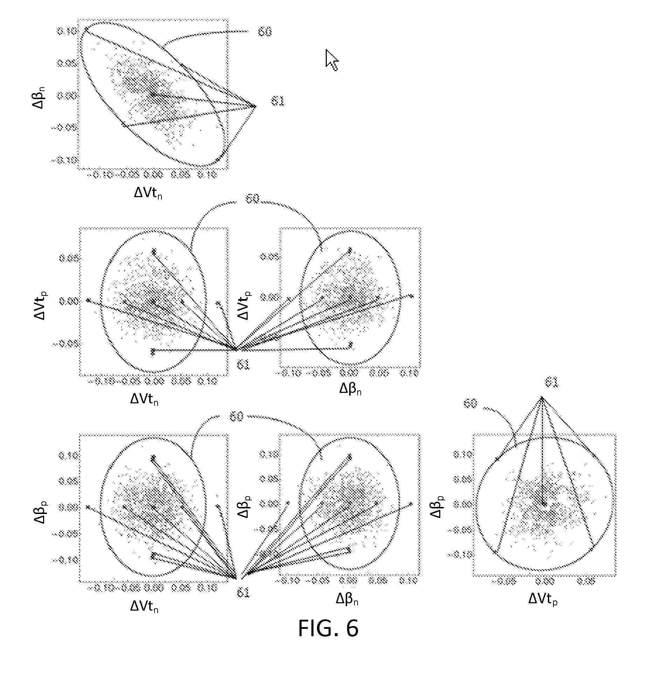

FIG. 6 presents the position of the Design of Experiments according to embodiments of the present invention for selecting the relevant DoE points according to the statistical variation parameters of an inverter. The selected Statistical Design of Experiments points preserve the correlations among any combination of statistical parameters and are positioned at the region of interest defined by the selectable confidence level (indicated by 60). Large square dots 61 represent the selected DoE points

After selection of a limited number $N_{doe}$ of DoE points, in accordance with embodiments of the present invention, simulations may be run on this selected ensemble of $N_{doe}$ DoE points - step 24. Using those runs, an appropriate response model, e.g. a regression model, may be computed to relate the statistical inputs to the simulated outputs - step 25.

Let $Y_i = H(\Gamma_i^B)$, for $1 \leq i \leq N_{doe}$ be the set of system responses corresponding to the $N_{doe}$ Design of Experiments points selected in accordance with embodiments of the present invention. A problem to be solved may then be how to find an optimal regression model such as an approximation function F for approximating true function H:

$$F(x_1,\ldots,x_p) \approx H(x_1,\ldots,x_p)$$

where p=2n so that $x_1=V_{t1}$, $x_2=\beta_1$, ..., $x_{p-1}=V_{tn}$, $x_p=\beta n$, and the function F is a nonlinear function such as

$$F(x_1,\ldots,x_p) = \alpha_{11}x_1 + \alpha_{12}x_1^2 + \ldots + \alpha_{1z}x_1^z + \ldots + \alpha_{pz}x_p^z$$

$$+ \zeta_{1_2 1}x_1^1 x_2^1 + \zeta_{1_3 1}x_1^1 x_3^1 + \zeta_{1_p 1}x_1^1 x_p^1 + \ldots + \zeta_{p_1 p-1_1}x_p^1 x_{p-1}^1$$

$$+ \zeta_{123}x_1 x_2 x_3 + \ldots + \zeta_{pp-1p-2}x_p x_{p-1}x_{p-2}$$

where z is the polynomial degree of the approximation function, $\alpha_{ij}$ is the coefficient multiplying variable $x_i^j$, and $\zeta_{ijkl}$ is the coefficient multiplying the interaction $x_i^j$ multiplied with $x_k^l$. These coefficients are determined by a fitting procedure such as for example Least Squares Fit. The approximation function may be employed to substitute extremely CPU time intensive Monte Carlo simulations.

Both the true function H and the best approximation function F are unknown. The approximation function F will be employed later to predict the outputs for all statistical simulations, e.g. MC combinations of $V_t$'s and $\beta$'s. For this purpose, using the full form of F as an approximation function would lead to bad predictions. This is because many linear and non-linear dependencies and cross dependencies are insignificant (and thus their coefficients should be ZEROED), although for example a least square (LS) regression algorithm finds coefficients different from zero for all terms of the given regression model. Thus, the LS algorithm, but also other regression algorithms, must have as input an appropriate function F. For this reason an algorithm in accordance with embodiments of the present invention is described for model selection, which is responsible for finding a sufficiently accurate model.

Embodiments of the present invention provide an algorithm for searching in the space of possible approximations and, without manual intervention or any previous knowledge about the system response (such as for example delay, power, etc.), provide the best possible non-linear function to approximate that response - step 32. The algorithm is divided into the following steps:

1. Initial Fit: fit a full linear model to the data;
2. Variable Screening: remove negligible terms; and
3. Model improvement: interactively add non-linear terms and cross terms.

The selection algorithm according to embodiments of the present invention uses a cost function to evaluate the model quality and to incrementally improve the accuracy of the regression model. By assessing this cost the model selection algorithm performs a search for the regression model that gives the optimum, for example minimum, cost. An example of a goodness of fit which may be used is Bayesian Information Criteria (BIC) proposed by Schwarz, which is given by:

$$BIC = \log(N_{doe})k - 2ln(L(\theta))$$

where k is the number of parameters and $L(\theta)$ is the likelihood of the model $\theta$ and $N_{doe}$ is the number of simulations.

Given $N_{doe}$ simulations, where $\varepsilon_i$ represents the disagreement between the model and the simulation i, the appropriate likelihood function of a regression model is the residual sum of squares given by $RSS = \sum_{i=0}^{N_{doe}} \varepsilon_i^2$ In this case BIC becomes:

$$BIC = \log(N_{doe})k - N_{doe}[ln(\frac{\sum_{i=0}^{N_{doe}}\varepsilon_i^2}{N_{doe}})] \qquad (14)$$

BIC is better than $L(\theta)$ for model selection because $L(\theta)$ always increases as the number of parameters is increased, while BIC penalizes an increase of the number of parameters in the model. Thus, by adding a penalty to the number of coefficients, BIC prioritizes a model with the minimum number of variables so that the regression is meaningful, reducing the risk of over-fitting.

In accordance with embodiments of the present invention, a first step to search for the best surrogate model is to fit the simplest regression model, which is a linear function with all the terms and no correlations, as in:

$$H_i = \alpha_{1_1} x_{1_i} + \alpha_{2_1} x_{2_i} + \ldots + \alpha_{p_1} x_{p_i} + \varepsilon_i \qquad (15)$$

where $H_i$ is the output of the $i^{th}$ point, $1 \le i \le N_{doe}$, run a system simulation, for example in hspice, which has the vector x of inputs. The LS method aims at minimizing the sum of errors given by $\sum_{i=0}^{Ndoe} \varepsilon_i$.

Not every variable has an influence on the system response. For instance, the rise delay of an inverter is only weakly related to $V_t$ and $\beta$ fluctuations of an NMOS transistor, and thus excluding these terms from the approximation function, or more generally those terms that do not have an influence on the system response, leads to a better model.

To solve this issue, in accordance with embodiments of the present invention a step for refinement of the linear model is described. This phase is accomplished by detecting and removing linear terms that have a negligible contribution to the system response. The listing of algorithm 1 presents a possible procedure to remove negligible linear terms.

---

**Algorithm 1** Variable screening

---

```
repeat
    for all variables x_i of function f do
        f_o ← remove term x_i of function f
        if AIC(f_o) < AIC(f) then
            store f_o in list L sorted by AIC(f_o)
        end if
    end for
    f ← pick model from list L with lowest AIC
until model does not improve
```

---

This method comprises iteratively checking the model BIC supposing one variable is removed, and then removing the variable for which removal leads to the best BIC. This iteration is performed until not removing any variables leads to a better BIC than removing one of the variables.

After executing the above procedure of variable screening, a linear model is obtained with a better BIC than the full linear model. This reduced model F is at the same time less complex and is a better approximation for H, and thus is more suitable for prediction.

A first order representation of the system response may not be sufficient for predicting the system characteristics with sufficient accuracy. As an example only, delay and power of a standard cell have non-linearities and cross-terms.

Algorithm 2 lists the procedure for finding a good non-linear model for the system response. It takes as inputs the simulations and the reduced linear model of algorithm 1. At each step, three operations are tried: (1) insert a higher order term (quadratic or cubic), (2) insert cross term for two existing terms and (3) remove an existing term. For each operation, the resulting model is stored in a list ranked by the model BIC. At each step, the operation that leads to the best local BIC is chosen. The iterative process stops when no operation leads to further model improvement.

---

**Algorithm 2** Model improvement

---

```
for k = 1..z do
    repeat
        for all variables x_i of function f do
            f_add ← add term x_i^k
            store f_add in list L sorted by AIC(f_add)
            f_remove ← remove term x_i
            store f_remove in list L sorted by AIC(f_remove)
            for all variables x_j of function f do
                f_correlation ← add term x_i × x_j
                store f_correlation in list L sorted by AIC(f_correlation)
            end for
        end for
        if best AIC stored in L < AIC(f) then
            f ← pick model from list L with lowest AIC
        end if
    until model does not improve
end for
```

---

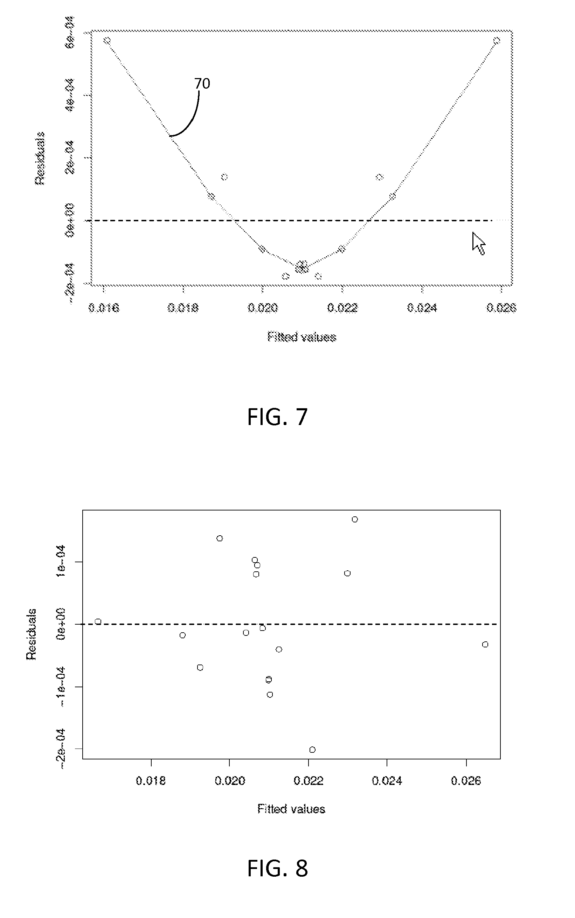

FIG. 7 and FIG. 8 respectively present the comparison between the initial full linear model and the best model found using the optimization loop, in the particular case of the delay of a logic gate. The residuals of the linear model present a U-shape curve 70, which means a disastrous mismatch in the tails and is an indication of using the wrong regression model. The non-linear model presents a satisfactory fitting: it is constantly near 0 over the output domain with few outliers in the middle of the domain. Also, the maximum residual of the non-linear model is smaller than the linear model ($1.5 \times 10^{-5}$ instead of $6 \times 10^{-4}$) and especially the tails fit much better. In fact the residuals of the non-linear model follow a Normal distribution and the linear one does not.

After approximating the fitted model, a plurality of samples is determined by performing a statistical analysis, for example by performing a statistical, e.g. Monte Carlo, simulation, on the determined response model, and by fitting a probability density function - step 33.

Thereafter, a method according to embodiments of the present invention may comprise generating a closed-form representation of the determined plurality of samples.

One of the characteristics of the statistical selection of DoE in accordance with embodiments of the present invention is the linear dependency between the number of points that need to be selected and the number of parameters being considered. In the context of the present invention there are 2n+1 DoE points to be selected, with n the number of variation parameters, and furthermore n=2T, with T the total number of electronic components, for example transistors, in the electronic system, in case each electronic component has two variation parameters. For big systems this may become problematic since the number of electronic components involved in their netlist description may be large (a few hundred), and estimating the system output by using a regression model still requires a transient simulation, for example electrical or behavioral, for each selected DoE. Thus, depending on the size of the system, the number of required simulations may still be prohibitive.

Many large systems (complex standard cells, sections of array circuits such as memories, highspeed asynchronous interfaces, etc) contain sub-circuits or parts of them that are only active when particular combinations of input stimuli are selected. Examples are the set/reset functionality of large Flip-Flops (FF) that activate or deactivate most of the electronic components involved in the normal operation of the gate depending on their settings. Moreover, those set/reset electronic components are usually not involved during normal operation of the FF as well. Hence, they have no influence on variations observed in responses such as set-up time, hold-time, clock-to-q, etc. Still they significantly contribute to overall electronic component count (typically 1/3 of the total). It is clearly inefficient to spend precious CPU time on performing simulations targeted to understanding how the main electronic system metric responses depend on the variation parameter of these electronic components. Simply said, if the sensitivity of the system response to the electronic components is null in nominal conditions it will remain null under process variation as well.

Moreover, there are situations when despite the device under consideration is involved in the operation of the electronic system, the electronic system response for a particular set of input stimuli is still independent of its status. Very simple examples can be found in logic gates when considering particular transitions at its output. For instance, when considering a NAND gate and when assuming there is an interest in creating a model estimator for the delay of the gate during a rise transition. In this situation, only those electronic components that change their status (e.g., in case the electronic components are transistors, from cut-off operation to linear or vice versa) will play a role on the transition at the output of the gate, hence in the timing response of that one. Consequently parameter variations on these electronic components will have a direct impact on variations in the timing response of the gate for a rise transition. On the other hand, those electronic components of which the status remains unchanged during the whole electronic system output response will have no impact on the timing response of the electronic system. Consequently parameter variations on these electronic components will not have a direct impact on variations in the timing response of the electronic system for such response.

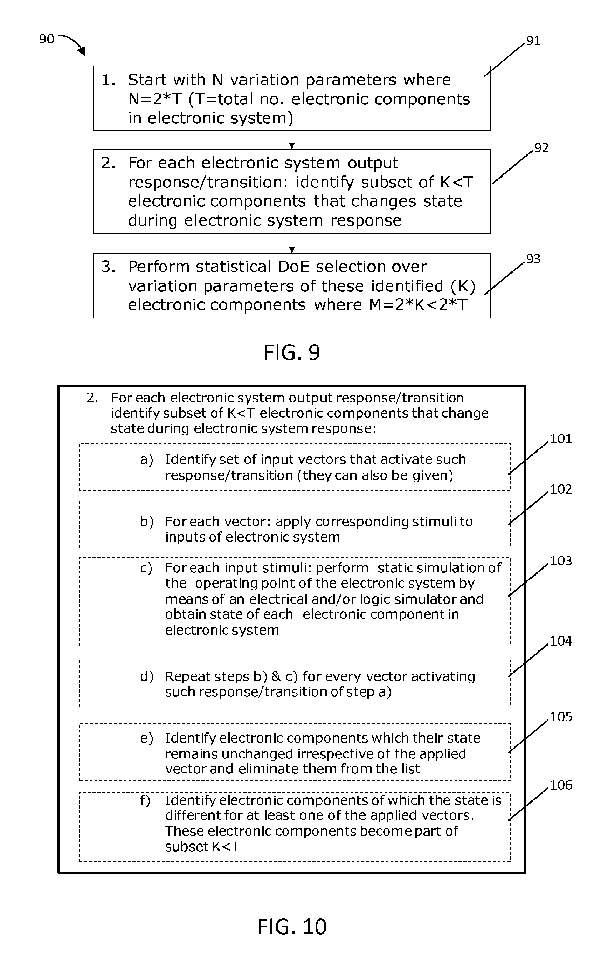

In order to solve this problem, in accordance with embodiments of the present invention, a method 90 is provided for identifying the number of electronic components that are strictly required to estimate the response of the electronic system under changes of the variation parameters. FIG. 9 depicts a high-level description of a method according to embodiments of the present invention, guaranteeing a sub-linear dependency between the required number of DoE points and the number of electronic components of the system. As a start - step 91- N variation parameters are considered, where N=2T, T being the total number of electronic components in the electronic system, and each electronic component having two variation parameters. From the initial set of T electronic components, a subset K (K<T) is identified - step 92 - that can be used to perform the statistical DoE (with 2m+1 points with m=2K) while not incurring any loss of accuracy. In this way, a sub-linear relationship is obtained between the number of required DoE points and the number of electronic components of the electronic system as required for electronic systems containing a large number of electronic components. It is to be emphasized that it is only of interest to identify these electronic components for which variations on their parameters will have a direct impact on variations on the response of the electronic system under a particular stimuli set. It is not of relevance to identify which electronic components are involved in the correct operation of the system, regardless the stimuli set. Thereafter, a statistical DoE selection is performed in accordance with embodiments of the present invention over the variation parameters of these identified K electronic components where M=2K<2T - step 93.

FIG. 10 depicts a detailed flow of the step 92 to identify a subset of K<T electronic components that change state during electronic system response under a set of input stimuli vectors by means of performing a static simulation of the operating point of the electronic system for each vector. In a first substep 101, a set of input vectors is identified that activate a response or transition. In substep 102, for each input vector, corresponding stimuli are applied to the inputs of the electronic system, and in substep 103 a static simulation of the operating point of the electronic system is performed by means of an electrical simulator or a logic simulator depending on the nature of the electronic system under consideration (transistor level circuit or gate level netlist) and the state of each electronic component in the electronic system is obtained for each input stimulus. Steps 102 and 103 are repeated for every vector activating the responses/transitions of step 101 - step 104. Electronic components are then identified of which the state remains unchanged irrespective of the applied vector. These electronic components are eliminated from the list - step 105. Moreover, electronic components are identified of which the state is different for at least one of the applied vectors. These electronic components become part of the subset of K electronic components, with K<T - step 106.

A Variability Aware Modeling (VAM) concept may be based upon Monte Carlo based computations performed at several levels of chip design: at each stage of the VAM, the variability of a set of input parameters is injected into an existing simulator in a Monte Carlo fashion, propagating the behavior of the design from one abstraction level to another to obtain the corresponding variability of the output parameters. E.g., at a given level, the variability of the transistor parameters may be injected into HSPICE simulations. For larger designs, the Monte Carlo sample size required to cover the output distribution over a sufficiently wide variability range to warrant accurate predictions up to the parametric yield levels commonly specified for current technologies at the system performance level, combined with the computation time required for simulation of a single instantiation of the input parameter set, would lead to a prohibitively large computational effort. This limitation can be partially intercepted with methods like Exponential Monte Carlo (EMC), but when the input distributions are themselves supplied in the form of a discrete set of MC runs performed at a lower abstraction level of the VAM, the input dataset has to be re sampled, and then the problem arises that extreme values are too often re-picked, leading to possibly severe artificial distortion of the tails of the output distribution found, including the (parametric) yield region of interest. To avoid the re-sampling, it is better to replace the discrete input sample dataset with a continuous "covering" input PDF approximation in accordance with embodiments of the present invention.

In a first step, Cumulative Distribution Function (CDF) levels are estimated for data points with median ranks. The exact median ranks for the ordered sample data points may be defined by the integral equation:

$$\frac{n! \int_0^{x_{rm}} x_r^{r-1}(1-x_r)^{n-r} dx_r}{(r-1)!(n-r)!} = \int_0^{x_{rm}} f_\beta[x_r] dx_r = \text{BetaRegularized}[x_r, r, n-r+1] = 0.5 \tag{16}$$

The Bénard formula is commonly used as a very good approximation for the solution of that equation:

$$x_{rm} \approx \frac{r-.3}{n+.4} \tag{17}$$

where r is the rank number of each element of the ordered sample data points and n is the total number of sample points.

In a second step, the estimated CDF levels are transformed into probits. The probit function is the inverse cumulative Normal distribution function. The problem with the regularized Beta distribution underlying the ranks is that for most of them, it is very asymmetric, especially for the outer ones, as illustrated in FIG. 12 (e.g. r=1 and r=7).

This renders the standard deviation less useful for estimation of weights for the median ranks. Therefore, the rank distribution is considered on a transformed scale.

When performing a Probit transform onto the cumulative distribution estimators, the error bars on them can be propagated to the Probits using the following propagation theorem: for a distribution with PDF f[x], the PDF corresponding with a monotonic function y=h[x] of x becomes:

$$\frac{f\left[h^{(-1)}[y]\right]}{\left|h'\left[h^{(-1)}[y]\right]\right|} \tag{18}$$

When h[x] is the Probit transform applied onto the cumulative distribution estimators $F_r$ of a sample, the theorem leads to:

$$\mathbf{h[x]} = \mathbf{F_N^{[-1]}}\left[\mathbf{F_r}\right] = \mathbf{x_{Nr}} \Rightarrow \mathbf{h^{[-1]}[y]} = \mathbf{F_N}\left[\mathbf{x_{Nr}}\right];$$

$$\left|\mathbf{h'}\left[\mathbf{h^{[-1]}[y]}\right]\right| = \frac{\partial \mathbf{F_N^{[-1]}}\left[\mathbf{F_N}\left[\mathbf{x_{Nr}}\right]\right]}{\partial \mathbf{F_N}\left[\mathbf{x_{Nr}}\right]} = \frac{1}{\dfrac{\partial \mathbf{F_N}\left[\mathbf{x_{Nr}}\right]}{\partial \mathbf{x_{Nr}}}} = \frac{1}{\mathbf{f_N}\left[\mathbf{x_{Nr}}\right]};$$

Thus, the PDF of $\chi_{Nr}$ becomes:

$$\mathbf{f}\left[\mathbf{x_{Nr}}\right] = \mathbf{f_N}\left[\mathbf{x_{Nr}}\right]\mathbf{f_\beta}\left[\mathbf{F_N}\left[\mathbf{x_{Nr}}\right], \mathbf{r}, \mathbf{n} - \mathbf{r} + \mathbf{1}\right] \qquad (19)$$

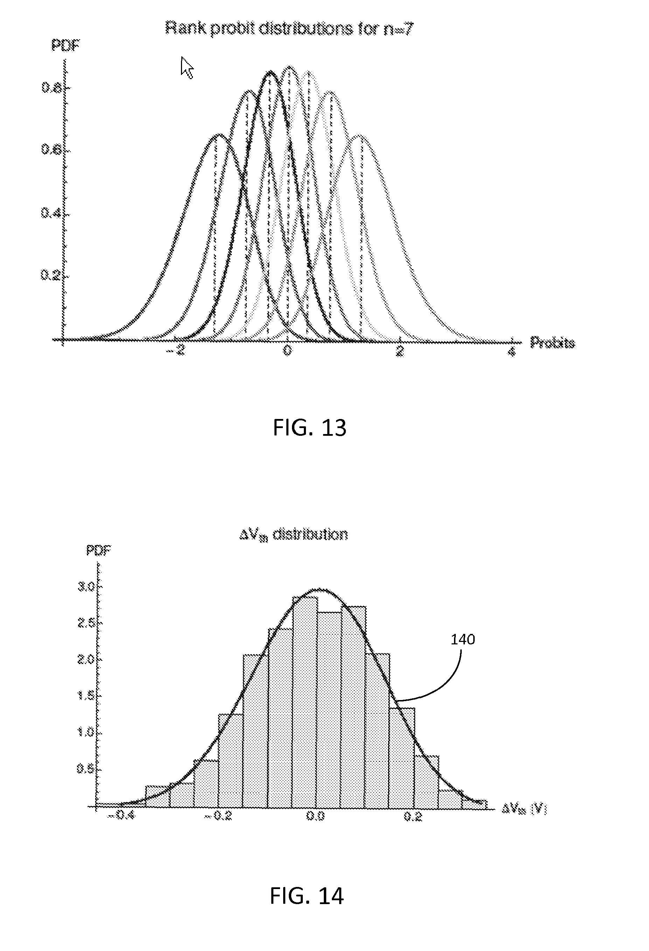

This transform restores the symmetry of the underlying distribution to a large extent, as illustrated in FIG. 13.

Using the transformed density function $f[x_{Nr}]$, the variance based weights for any of the median rank Probits $\chi_{Nrm}$ can be computed as:

$$\mathbf{w_{Nr}} = \frac{\mathbf{1}}{\displaystyle\int_{-\infty}^{\infty} \left(\mathbf{x_N} - \mathbf{x_{Nrm}}\right)^2 \mathbf{f_N}\left[\mathbf{x_N}\right]\mathbf{f_\beta}\left[\mathbf{F_N}\left[\mathbf{x_N}\right], \mathbf{r}, \mathbf{n} - \mathbf{r} + \mathbf{1}\right]\mathbf{dx_N}} \qquad (20)$$

with

$$\mathbf{x_{Nrm}} \approx \mathbf{F_N^{[-1]}}\left[\frac{\mathbf{r} - \mathbf{.3}}{\mathbf{n} + \mathbf{.4}}\right] \qquad (21)$$

This way, fixed weights are computed for median ranks probits $X_{Nrm}$, which can be stored into a support table along with the $X_{Nrm}$ values.

In a next step, a weighted linear fit may be performed on the probits using the fixed weights multiplied with the variable Gaussian weights.

The interpolation is based upon a variable weighted linear probit interpolation. Weighting is performed in 2 different ways: each Bénard median rank probit estimator receives a weight equal to the inverse of the variance of this estimator (times the number of ties in the dataset, if present). As the probit variance computation is a time consuming process based upon numerical integration, it is better to compute and store the fixed weights first. Then, these weights are input to a next module which computes the local sigma values. These weights and the local sigma values are stored together with the dataset, thus the data is represented by 4 columns: 1) dataset; 2) CDF estimator Probits 3) Probit weights and 4) local sigma values. Next, the module performs a different weighted linear interpolation for each x value supplied to it using Gaussian PDF weights depending on the distance from each input x value to the running x value in combination with the fixed weights for the Probit estimates.

$$\mathbf{w_k} = \mathbf{w_{Nr}}\mathbf{w_{Gr}} \qquad (22)$$

with

$$\mathbf{w}_{Gr} = \frac{e^{-\frac{1}{2}\left(\frac{\mathbf{x}-\mathbf{x}_r}{\sigma_{wr}}\right)^2}}{\sigma_{wr}}$$

$$(23)$$

The weighted least squares intercept and slope of the weighted Probit curve are defined by:

$$\mathbf{a}_0 = \frac{\left(\sum_{r=1}^{n} \mathbf{w}_r \mathbf{x}_r^2\right)\sum_{r=1}^{n} \mathbf{w}_r \mathbf{y}_r - \left(\sum_{r=1}^{n} \mathbf{w}_r \mathbf{x}_r\right)\sum_{r=1}^{n} \mathbf{w}_r \mathbf{x}_r \mathbf{y}_r}{\left(\sum_{r=1}^{n} \mathbf{w}_r\right)\sum_{r=1}^{n} \mathbf{w}_r \mathbf{x}_r^2 - \left(\sum_{r=1}^{n} \mathbf{w}_r \mathbf{x}_r\right)^2}$$

$$\mathbf{a}_1 = \frac{\left(\sum_{r=1}^{n} \mathbf{w}_r\right)\sum_{r=1}^{n} \mathbf{w}_r \mathbf{x}_r \mathbf{y}_r - \left(\sum_{r=1}^{n} \mathbf{w}_r \mathbf{x}_r\right)\sum_{r=1}^{n} \mathbf{w}_r \mathbf{y}_r}{\left(\sum_{r=1}^{n} \mathbf{w}_r\right)\sum_{r=1}^{n} \mathbf{w}_r \mathbf{x}_r^2 - \left(\sum_{r=1}^{n} \mathbf{w}_r \mathbf{x}_r\right)^2}$$

$$(24)$$

This way, all data points contribute in the weighted linear fit, but "nearby" data points receive larger weight, wherein the extra local spread parameter $\sigma_{wr}$ in $w_{Gr}$ defines "nearby". The variable Gaussian weighting induces an extra complication however, as the $a_0$ and $a_1$ coefficients become a function of x.

$$\mathbf{x}_N[\mathbf{x}] = \mathbf{F}_N^{[-1]}[\mathbf{F}[\mathbf{x}]] = \mathbf{a}_0[\mathbf{x}] + \mathbf{a}_1[\mathbf{x}] \cdot \mathbf{x}$$

$$(25)$$

Thus the PDF of the approximation can be computed as:

$$\mathbf{f}[\mathbf{x}] \approx \mathbf{f}_N[\mathbf{x}_N]\frac{\partial \mathbf{x}_N[\mathbf{x}]}{\partial \mathbf{x}} = \mathbf{f}_N[\mathbf{x}_N]\left(\mathbf{a}_0'[\mathbf{x}] + \mathbf{a}_1'[\mathbf{x}] \cdot \mathbf{x} + \mathbf{a}_1[\mathbf{x}]\right)$$

$$(26)$$

Also because of the variable weighting, extra sums leading to the coefficient derivatives $a_0'[x]$ and $a_1'[x]$ are required for the PDF approximation. It is to be noted that the special case of a constant $a_1$ value corresponds with a Normal distribution.

In a next step, variable Gaussian weights may be auto-calibrated.

The inverse of the local slope of the weighted LS Probit curve reflects the local data spread, also at the data points:

$$\sigma_{wr} = \frac{1}{\mathbf{a}_1[\mathbf{x}_r]}$$

$$(27)$$

Based on self-consistency, the local $\sigma_{wr}$ values can be calibrated with the following procedure:

- Initialize all $\sigma_{wr}$ values to s' of dataset

- Compute $a_1[x]$ values in all $x_r$

- Store $\dfrac{1}{\mathbf{a}_1}$ as the new $\sigma_{wr}$ values

- Iterate till convergence

Thus, the distribution sample is extended into the following support table for the interpolation: { data point $x_r$, Probit estimate $x_{Nrm}$, fixed Probit weight $w_{Nr}$, local sigma value $\sigma_{wr}$ for variable weighting}.

One aspect to consider in the above-described interpolation method according to embodiments of the present invention is that it does not exclude descending CDF regions in between relatively widely spaced data points (e.g. outliers) in the tails of the distribution sample, so that it behaves properly when applied to statistically well behaved sample data sets. This is, however, a.o. the case for all essentially digital parametric responses of electronics systems.

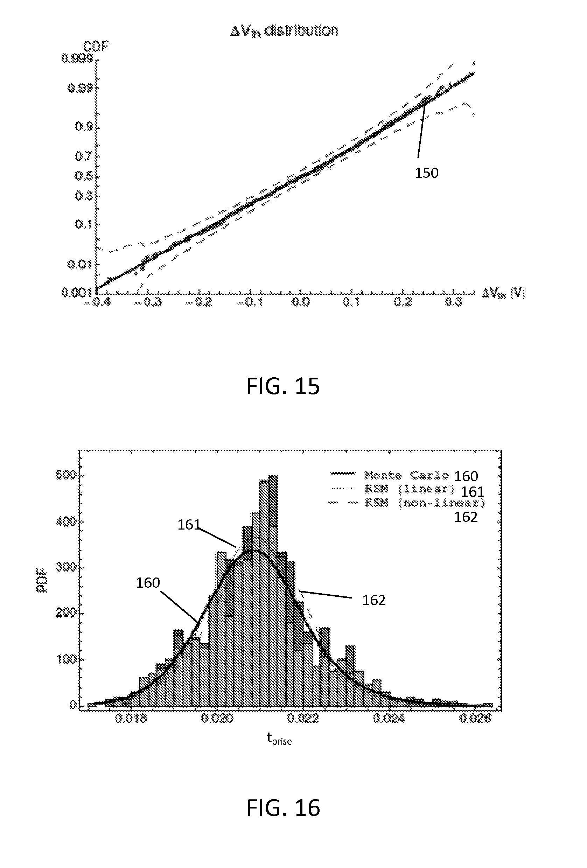

FIG. 14 and FIG. 15 illustrate the method according to embodiments of the present invention with a sample interpolation of a threshold voltage distribution both for the PDF (graph 140) and the CDF (graph 150), respectively.

A covering CDF representation is constructed from a limited size MC sample that

- avoids histograms (problem with binning choices),
- is a continuous function,
- mimics the underlying PDF with sufficient accuracy,
- reproduces central values and second order central moments, and
- avoids re-picking entries when re-sampling with larger sample size.

A final step of a method according to embodiments of the present invention may comprise running a full statistical simulation, e.g. the full Monte Carlo simulation, interpolating over the function approximating the earlier simulation, e.g. electrical simulation or behavioral simulation. In other words, the statistics of $F(x), \forall x \in \Gamma^M$ are computed. The complexity of applying one input vector to function F is O(1) and this is many orders of magnitudes faster than running one electrical simulation.

Example

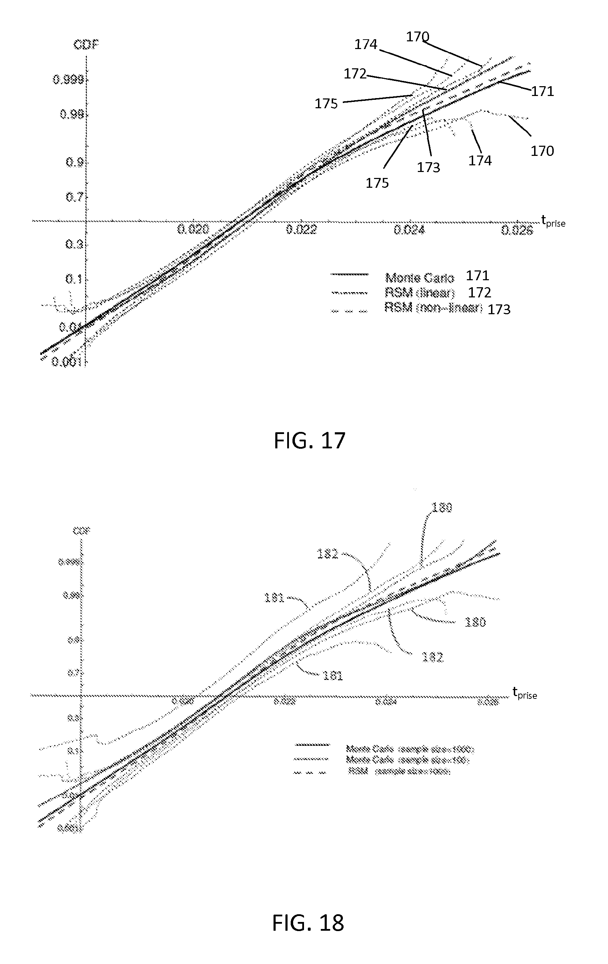

FIG. 16 and FIG. 17 present the distributions of time to rise of a NAND2 gate, comparing Monte Carlo (graph 160) with RSM according to embodiments of the present invention using the linear (graph 161) and the improved non-linear models (graph 162). FIG. 16 shows the comparison of the PDF, while FIG. 17 shows the CDF on a probit scale, which magnifies discrepancies in the tails of the distributions.

FIG. 17 shows that the interpolation made using the improved non-linear function 173 according to embodiments of the present invention lies within the confidence intervals 170 of MC (graph 171), implying the RSM has no statistical difference from the MC using electrical simulations. The confidence intervals of the non-linear function 173 are indicated as 174. Also indicated in FIG. 17 is the linear RSM (graph 172) with confidence intervals 175. Prior art Monte Carlo simulation consists of 1000 runs of Cadence NDC (2h), while in this case RSM according to embodiments of the present invention needs only 17 runs, whose runtime is approximately 1 minute. The time for performing the pre-processing step on the statistical input domain, for model improvement and for interpolating the approximation function with the Monte Carlo inputs is around 5-10 seconds. Although RSM requires only 17 HSPICE runs, a sample size of 1000 is generated from the surrogate models. It can be seen that the non-linear model has better accuracy than the linear model.

FIG. 18 shows a comparison between RSM in accordance with embodiments of the present invention and MC HSPICE as a function of variable sample sizes. This Figure shows that if the number of MC runs is decreased from 1000 to 100, the confidence bands get significantly wider (from confidence bands 180 to confidence bands 181), which means that the uncertainty in the estimates decreases and the interval where the actual statistics may lie increases. On the other hand, RSM using sample size of 1000 has similar accuracy to MC using sample size of 1000 (indicated by confidence bands 182).

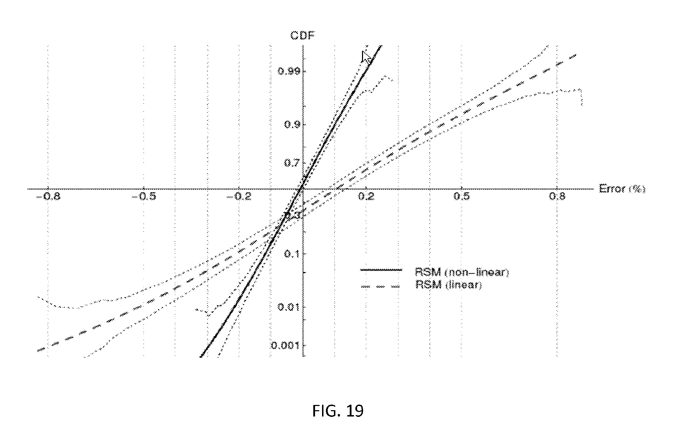

FIG. 19 presents the point-by-point distribution of relative errors produced by linear and non-linear RSM in accordance with embodiments of the present invention. A linear regression model can have discrepancies up to $\pm 90\%$ compared to MC. The non-linear model produced by the model improvement algorithm presents the average of errors as being 1% and standard deviation as 8%. Also, the errors of the RSM follow a Normal distribution, which means there is no systematic cause of discrepancies.

The MC approach requires approximately 2 hours for one cell. A standard cell library usually has around 2000 cells. This translates into a total of 165 days to perform MC simulations to characterize the library. On the other hand, RSM in accordance with embodiments of the present invention requires 1 minute per cell, meaning a total of 30h for characterizing the complete cell library. Thus, a speedup of two orders of magnitude (from 165 days to 1 day) is achieved without loss of accuracy when using a method in accordance with embodiments of the present invention.

**EP 2 360 607 A1**

The foregoing description details certain embodiments of the invention. It will be appreciated, however, that no matter how detailed the foregoing appears in text, the invention may be practiced in many ways. While the invention has been illustrated and described in detail in the drawings and foregoing description, such illustration and description are to be considered illustrative or exemplary and not restrictive. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1.   Method for performing a characterization of a description of the composition of an electronic system in terms of a plurality of components used, performances of the plurality of components being described by at least two statistical parameters and at least one deterministic parameter, the method comprising
selecting a plurality of design of experiments points,
performing simulations on the selected plurality of design of experiments points, thus obtaining electrical system responses, and
determining a response model using the plurality of selected design of experiments points and the electrical system responses,
wherein selecting the plurality of design of experiments points comprises making a first selection of design of experiments points for the statistical parameters, and making a second selection of design of experiments points for the at least one deterministic parameter.

2.   Method for performing a characterization of a description of the composition of an electronic system according to claim 1, wherein selecting the plurality of design of experiments points comprises
entering a statistical confidence level,
and wherein making a first selection of DoE points for the statistical parameters comprises selecting points of a statistical parameter distribution which are representative for the statistical parameters based on representativeness of the statistical confidence level behind such statistical parameter distribution.

3.   Method for performing a characterization of a description of the composition of an electronic system according to any of the previous claims,
wherein making a first selection of design of experiment points for the statistical parameters includes constructing a multi-dimensional probability density function representing a multivariate statistics dataset of the description of the composition of the electronic system, the probability density function showing a distribution of statistical parameters, and selecting the design of experiment points for the statistical parameters based on the distribution of statistical parameters.

4.   Method according to claim 3, wherein constructing a multi-dimensional probability density function representing multivariate statistics of the description of the composition of the electronic system comprises
partitioning the multivariate statistics dataset into a plurality of cluster components,
fitting a multivariate distribution to each cluster component and determining its probability density function, and accumulating the multiple probability density functions of the cluster components into a proportional sum weighted by cluster component size, this being the multi-dimensional probability density function representing the multivariate statistics dataset of the description of the composition of the electronic system.

5.   Method according to any of claims 3 or 4, wherein the multi-dimensional probability density function is n-dimensional, and the number of selected design of experiments points is 2n+1.

6.   Method according to claim 5, wherein the multi-dimensional probability density function is represented in a PDF contour plot by an ellipsoid contour, and wherein the design of experiments points are selected as lying on the one hand within a predetermined first margin of the ellipsoid describing the contour encompassing a predetermined percentage of the total distribution and on the other hand within a predetermined second margin of the intersects thereof with the principal ellipsoid axes.

**7.** Method according to claim 6, wherein the design of experiments points are selected as lying both on the ellipsoid describing the contour encompassing a predetermined percentage of the total distribution and on the intersects thereof with the principal ellipsoid axes.

**8.** Method according to any of the previous claims, wherein determining a response model comprises detecting and removing linear terms that have a negligible contribution to the system response.

**9.** Method according to any of the previous claims, furthermore comprising, before selecting a plurality of design of experiments points, identifying individual components of the electronic system which have no influence on the circuit response.

**10.** System-level simulator adapted for carrying out a method as in any of claims 1 to 9.

**11.** System-level simulator according to claim 10, comprising
an input port for receiving a description of the composition of an electronic system in terms of a plurality of components used,
an input port for receiving a distribution of statistical properties of the performances of the plurality of components of the electronic system,
an input port for receiving a distribution of at least one deterministic parameter of the plurality of components of the electronic system,
a selector for selecting a plurality of design of experiments points,
a simulator for performing simulations on the selected plurality of design of experiments points, thus obtaining electrical system responses,
a modeling unit for determining a response model using the plurality of selected design of experiments points and the electrical system responses,
wherein the selector comprises a first sub-selector for making a first selection of design of experiments points for the statistical parameters and a second sub-selector for making a second selection of design of experiments points for the at least one deterministic parameter

**12.** System-level simulator according to claim 11, furthermore comprising an input port for receiving a statistical confidence level, and
wherein the selector is adapted for selecting those points of a statistical parameter distribution which are representative for the statistical parameters based on representativeness of the statistical confidence level behind such statistical parameter distribution.

**13.** Computer program product for executing any of the methods as claimed in claims 1 to 9 when executed on a computing device associated with a system-level simulator.

**14.** A machine readable data storage storing the computer program product of claim 13.

**15.** Transmission of the computer program product of claim 13 over a local or wide area telecommunications network.

Netlist

11

10

13

Electrical simulation
h(vt1, b1, … , vtn , bn)

i++

Distribution
dVt/dBeta
of transistors

12

14

i<N?

TRUE

FALSE

15

Compute statistical information
Fit Probability Density Function

FIG. 1 – PRIOR ART

20

Input domain
(statistical)

21

23

Selection of
DoE points

Input domain
(deterministic)

22

24

Simulations

25

Response
model fitting

FIG. 2

30

**Select Ndoe artificial points** — 31

Netlist

j++

**Electrical simulation**
**h(vt1,b1,...vtn,bn)** — 24

j<Ndoe?  TRUE

FALSE

Distribution
dVt/dBeta
of transistors — 21

**Build RSM Fit:**
**Find optimal function f(vt1,b1,...,xvtn,bn) which**
**approximates hspice output h(vt1,b1,...,vtn,bn)** — 25

i++

**Approximation function:**
**f(vt1,b1,...vtn,bn)** — 32

i<N?  TRUE

FALSE

**Compute statistical Information**
**Fit Probability Density Function** — 33

FIG. 3

$V_{dd}$

$I_{charge}$

$I_{peak}$

$C_L$

Input Domain (Statistical) —21

22— Input Domain (Deterministic)

$\Delta\beta$, $\Delta Vt$

Slew-in, Load

Statistical DoE Multi-Normal Clustering —31

Deterministic DoE *Full-Factorial Design, others*

Few selected N DoE points

N Electrical Simulations —24

N DoE points, N Circuit responses

Model selection & improvement

CDF

Response Modeling *Variable screening, space rotation & perturbation terms* 25

$\mu_{nonlinear}$ = 0.9% $\sigma_{nonlinear}$ = 8.8%

$\Delta\beta_n$

$\Delta Vt_n$

Error (%)

Approximation function

$(2^n$ number of variation parameters +1) = – statistically meaningful DoE

33 Monte Carlo loop on response model

$\mu_{linear}$ = 10.6% $\sigma_{linear}$ = 26.5%

Quickly obtain large no. of statistical responses

Ideal Response

Statistical representation of output in closed form (statistical covering)

FIG. 4

FIG. 5

FIG. 6

FIG. 7

FIG. 8

90

91

1. Start with N variation parameters where N=2*T (T=total no. electronic components in electronic system)

92

2. For each electronic system output response/transition: identify subset of K<T electronic components that changes state during electronic system response

93

3. Perform statistical DoE selection over variation parameters of these identified (K) electronic components where M=2*K<2*T

FIG. 9

2. For each electronic system output response/transition identify subset of K<T electronic components that change state during electronic system response:

101

    a) Identify set of input vectors that activate such response/transition (they can also be given)

102

    b) For each vector: apply corresponding stimuli to inputs of electronic system

103

    c) For each input stimuli: perform static simulation of the operating point of the electronic system by means of an electrical and/or logic simulator and obtain state of each electronic component in electronic system

104

    d) Repeat steps b) & c) for every vector activating such response/transition of step a)

105

    e) Identify electronic components which their state remains unchanged irrespective of the applied vector and eliminate them from the list

106

    f) Identify electronic components of which the state is different for at least one of the applied vectors. These electronic components become part of subset K<T

FIG. 10

FIG. 11

FIG. 12

Rank probit distributions for n=7

FIG. 13

ΔV$_{th}$ distribution

140

FIG. 14

FIG. 15

FIG. 16

FIG. 17

FIG. 18

FIG. 19

Europäisches
Patentamt

European
Patent Office

Office européen
des brevets

## EUROPEAN SEARCH REPORT

Application Number

EP 10 18 9434

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/228846 A1 (MCCONAGHY TRENT LORNE [CA] ET AL) 10 September 2009 (2009-09-10) <br> * paragraph [0042] * <br> * paragraph [0077] * <br> * the whole document * <br> ----- | 1-15 | INV. <br> G06F17/50 |
| X <br> A | US 2007/174030 A1 (YUN SUNG-HEE [KR] ET AL) 26 July 2007 (2007-07-26) <br> * paragraph [0066] * <br> * figures 5,6 * <br> * the whole document * <br> ----- | 1 <br><br> 2-15 | |
| X <br> A | US 2004/064296 A1 (SAXENA SHARAD [US] ET AL) 1 April 2004 (2004-04-01) <br> * paragraph [0023] - paragraph [0033] * <br> * the whole document * <br> ----- | 1 <br><br> 2-15 | |

TECHNICAL FIELDS
SEARCHED      (IPC)

G06F

The present search report has been drawn up for all claims

| Place of search | Date of completion of the search | Examiner |
|---|---|---|
| Munich | 6 April 2011 | Wellisch, J |

EPO FORM 1503 03.82 (P04C01)

## ANNEX TO THE EUROPEAN SEARCH REPORT
## ON EUROPEAN PATENT APPLICATION NO.

EP 10 18 9434

This annex lists the patent family members relating to the patent documents cited in the above-mentioned European search report.
The members are as contained in the European Patent Office EDP file on
The European Patent Office is in no way liable for these particulars which are merely given for the purpose of information.

06-04-2011

| Patent document cited in search report | | Publication date | Patent family member(s) | | Publication date |
|---|---|---|---|---|---|
| US 2009228846 | A1 | 10-09-2009 | CA | 2656850 A1 | 03-09-2009 |
| US 2007174030 | A1 | 26-07-2007 | NONE | | |
| US 2004064296 | A1 | 01-04-2004 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6381564 B

**Non-patent literature cited in the description**

- **A. ALVAREZ et al.** Application of statistical design and response surface methods to computer-aided vlsi device design. *IEEE Trans. on CAD,* February 1988, vol. 7 (2), 272-288